# EUROPÄISCHE PATENTANMELDUNG

(11) **EP 4 807 377 A1**
(43) Veröffentlichungstag der Anmeldung: **16.09.2026**
(21) Anmeldenummer: 26162835.8
(22) Anmeldetag: 06.03.2026
(51) Int. Cl.: G01R 31/26

(54) **VERFAHREN UND VORRICHTUNG ZUR BESTIMMUNG EINES GESUNDHEITSZUSTANDS EINES LEISTUNGSHALBLEITERELEMENTS**

(30) Priorität: 12.03.2025 DE 102025109416
(71) Anmelder: Volkswagen Aktiengesellschaft, 38440 Wolfsburg (DE)
(72) Erfinder: Tashakor, Nima, 38440 Wolfsburg (DE); Otto, Alexander, 38440 Wolfsburg (DE)

(57) **Zusammenfassung**

Die Erfindung betrifft ein Verfahren und eine Vorrichtung zur Bestimmung eines Gesundheitszustands (SOH) eines Leistungshalbleiterelements (1), umfassend die Schritte:
• Bestimmen eines Zustandssignals (Z), welches für eine Gate-Spannung oder einen Gate-Strom repräsentativ ist,
• Bestimmen des Gesundheitszustands (SOH) in Abhängigkeit des Zustandssignals (Z),
dadurch gekennzeichnet, dass
das Zustandssignal (Z) für einen Zustand bestimmt wird, in dem das Leistungshalbleiterelement (1) mit einer Diagnosefrequenz (fd) betrieben wird, die höher als eine maximale Normalbetriebsfrequenz (fn) ist und/oder in dem ein Gate-Widerstand des Leistungshalbleiterelements (1) auf eine Diagnosewert eingestellt wird, der höher als ein maximaler Normalbetriebswiderstand ist.

## Beschreibung

Die Erfindung betrifft ein Verfahren und eine Vorrichtung zur Bestimmung eines Gesundheitszustands eines Leistungshalbleiterelements.

Leistungshalbleiterelemente wie beispielsweise IGBT (Insulated-Gate Bipolar Transistors) oder MOSFET (Metal-Oxide-Semiconductor Field-Effect Transistors) werden für eine Vielzahl von Anwendungen eingesetzt. Z.B. werden solche Leistungshalbleiterelemente zur Wechselrichtung einer Gleichspannung eingesetzt, beispielsweise um eine elektrische Antriebsmaschine eines Fahrzeugs zu betreiben.

MOSFETs und IGBTs können aus verschiedenen Gründen altern, z.B. aufgrund einer elektrischen Beanspruchung. Diese kann z.B. zu dem Effekt des Gate-Oxid-Abbaus führen. Dieser bezeichnet eine allmähliche Degradation oder physische Schädigung der Oxidschicht im MOSFET oder IGBT, die u.a. durch langfristige elektrische Belastungen bedingt sein kann.

Ein weiterer Alterungseffekt ist so genannte Ladungstrapping, also das Einfangen von Ladungsträgern (Elektronen oder Löchern) in Defekten innerhalb des Gate-Oxids oder an Grenzflächen (z. B. zwischen dem Silizium und dem Oxid). Dieser Effekt kann z.B. durch die so genannte Hot Carrier Injection (HCl) verursacht sein, wobei bewegliche Ladungsträger mit hoher Energie in das Gate-Oxid eindringen und sich hierdurch die elektrischen Eigenschaften ändern.

Neben weiteren nachteiligen Auswirkungen kann sich durch das erläuterte Ladungstrapping oder den Gate-Oxid-Abbau ein Leckstrom im Leistungshalbleiterelement erhöhen, wobei dies zu einer zusätzlichen, unerwünschten Erwärmung des Leistungshalbleiterelements führen kann. Auch kann sich zum vollständigen Schalten des Leistungshalbleiterelements erforderliche Ladung in unerwünschter Weise erhöhen. Dies führt zu langsameren Schaltvorgängen und höheren Verlustleistungen.

Daher ist eine regelmäßige Überwachung und eventuell eine Anpassung der Ansteuerschaltung oder ein Austausch des Leistungshalbleiterelements gewünscht.

Ebenfalls gewünscht ist es, einen Gesundheitszustand des Leistungshalbleiterelements zu kennen, insbesondere wenn dieses eine der Schlüsselkomponenten des Antriebssystems ist, da eine frühzeitige Erkennung von Fehlern oder sich entwickelnden Fehlern Beschädigungen und einen eingeschränkten Fahrbetrieb vermeiden kann.

Die US 11,239,839 B2 offenbart ein Leistungsversorgungssystem mit einem Hochvolt-IBGT und einer Gatetreiberschaltung für den Hochvolt-IBGT sowie einer Steuerschaltung für die Gatetreiberschaltung. wobei eine Verschlechterung des Hochvolt-IGBTs auf der Grundlage einer digitalisierten Gatespannung des Hochvolt-IGBTs bestimmt wird, wenn sich der Hochvolt-IGBT in der Sättigung befindet.

Die EP 3 879 289 A1 offenbart ein System mit einem Halbleiterbauelement und einer Gate-Treiberplatine. Die Gate-Treiberplatine liefert eine Spannung an das Halbleiterbauelement. Das System umfasst auch einen Controller und eine Überwachungsschaltung. Der Controller steuert die von der Gate-Treiberplatine bereitgestellte Spannung. Die Überwachungsschaltung ist mit der Gate-Treiberplatine gekoppelt, um den Betrieb der Steuerung und des Halbleiterbauelements zu überwachen.

Die US 2017/0350934 A1 offenbart eine Abschätzung des Zustands von Komponenten von Energieumwandlungssystemen und insbesondere des Zustands von Leistungselektronikschaltern wie MOSFETs, SiC-MOSFETs und IGBTs, die beispielsweise in Wechselrichter-/Gleichrichtersystemen verwendet werden können.

Es stellt sich daher das technische Problem, ein Verfahren und eine Vorrichtung zur Bestimmung eines Gesundheitszustands eines Leistungshalbleiterelements zu schaffen, die eine einfache und zuverlässige Bestimmung des Gesundheitszustands ermöglichen.

Die Lösung des technischen Problems ergibt sich durch die Gegenstände mit Merkmalen der unabhängigen Ansprüche. Weitere vorteilhafte Ausgestaltungen der Erfindung ergeben sich aus den Unteransprüchen.

Vorgeschlagen wird ein Verfahren zur Bestimmung eines Gesundheitszustands eines Leistungshalbleiterelements. Dieses kann ein MOSFET, ein SiC-MOSFET oder ein IBGT sein.

Das Leistungshalbleiterelement kann insbesondere Bestandteil eines Wechselrichters zur Bereitstellung einer Wechselspannung zum Betrieb einer elektrischen Antriebsmaschine eines Fahrzeugs sein.

Das Leistungshalbleiterelement weist einen Gate-Anschluss auf. Dieser ist elektrisch mit einer Gatetreiber-Einrichtung, z.B. einer Gatetreiber-Schaltung, verbunden. Insbesondere kann der Gate-Anschluss mit einem halbleiterelementseitigen Ausgangsanschluss der Gatetreiber-Einrichtung verbunden sein. Dieser Gate-Anschluss dient zur Steuerung des Transistors und damit zur Regelung des Stromflusses zwischen Kollektor und Emitter (IGBT) bzw. Drain und Source (MOSFET). Der Gate-Anschluss verhält sich wie eine Reihenschaltung aus einem Widerstand und einer Kapazität, die durch eine Steuerspannung umgeladen werden muss, um den Halbleiter zu aktivieren oder zu deaktivieren.

Zur Steuerung wird von der Gatetreiber-Einrichtung die Gate-Spannung eingestellt bzw. verändert., wodurch sich auch ein Gate-Strom einstellt, also ein von der Gatetreiber-Einrichtung zum Gate-Anschluss fließender Strom. Mit anderen Worten stellt die Gatetreiber-Einrichtung die notwendige (Gate-)Spannung und den (Gate-)Strom bereit, um das Gate des Leistungshalbleiterelements ein- und auszuschalten.

Zusätzlich zur elektrischen Verbindung mit dem Halbleiterbauelement kann die Gatetreibereinrichtung mit einer oder mehreren der folgenden Elemente elektrisch verbunden sein:
- mit mindestens einer Steuereinrichtung,
- mit mindestens einer Spannungsversorgungsquelle, insbesondere mit mindestens einer halbleiterelementseitigen (sekundärseitigen) Spannungsversorgungsquelle und/oder einer steuereinrichtungsseitigen (primärseitigen) Spannungsversorgungsquelle.

Die Steuereinrichtung kann als Recheneinrichtung ausgebildet sein, wobei eine Recheneinrichtung insbesondere als Mikrocontroller oder integrierte Schaltung ausgebildet ist oder eine(n) solche(n) umfasst. Die Steuereinrichtung dient zur Erzeugung bzw. Bereitstellung eines Steuersignals zum Betrieb der Gatetreiber-Einrichtung, wobei die Gatetreiber-Einrichtung insbesondere eine Spannungs- und Stromverstärkung vornehmen und gegebenenfalls Schutzfunktionen bereitstellen kann. Insbesondere kann das Steuersignal eine niedrigere Spannungsamplitude als das Gate-Spannungssignal aufweisen.

Die Gatetreiber-Einrichtung kann insbesondere als isolierte Gatetreiber-Einrichtung ausgebildet sein. Eine solche isolierte Gatetreiber-Einrichtung kann verwendet werden, um ein Leistungshalbleiterelement elektrisch getrennt von der Steuerelektronik anzusteuern. Dadurch wird Potentialtrennung ermöglicht, was besonders bei Hoch-spannungsanwendungen (z. B. Motorsteuerungen, Wechselrichter) gewünscht sein kann. Eine solche Gatetreiber-Einrichtung kann eine Primärseite und eine Sekundärseite aufweisen, die elektrisch voneinander isoliert sind. Die Primär-und Sekundärseite können durch verschiedene Spannungsversorgungsquellen versorgt werden.

Somit kann die Gatetreiber-Einrichtung mehrere Anschlüsse aufweisen, insbesondere
- einen halbleiterelementseitigen, insbesondere einen primärseitigen, Ausgangsanschluss, an dem die Gate-Spannung bereitgestellt wird,
- einen halbleiterelementseitigen, insbesondere primärseitigen, Spannungsversorgungsanschluss zum Anschluss an eine erste, insbesondere primärseitige, Spannungsversorgungsquelle,
- einen steuereinrichtungsseitigen, insbesondere sekundärseitigen, Anschluss zum Empfang eines Steuersignals,
- einen steuereinrichtungsseitigen, insbesondere sekundärseitigen, Spannungsversorgungsanschluss zum Anschluss an eine weitere, insbesondere sekundärseitige, Spannungsversorgungsquelle.

Das Verfahren umfasst folgende Schritte.

In einem ersten Bestimmungsschritt wird ein Zustandssignal bestimmt, welches für eine Gate-Spannung oder einen Gate-Strom repräsentativ ist. Abhängig vom verwendeten Leistungshalbleiterelement kann die Gate-Spannung eine Gate-Source-Spannung oder aber einer Drain-Source-Spannung, eine Gate-Emitter-Spannung oder aber eine Gate-Collector-Spannung sein. Das Bestimmen des Zustandssignals umfasst hierbei insbesondere das Bestimmen eines zeitlichen Verlaufs des Zustandssignals. Das Bestimmen kann ein Messen sein. In diesem Fall kann das Zustandssignal ein Messsignal sein und durch eine Einrichtung zur Erfassung des Zustandssignals, insbesondere einen Sensor wie einen Strom- oder Spannungssensor, erfasst werden und insbesondere durch das Ausgangssignal dieser Einrichtung zur Erfassung bereitgestellt sein. Der Begriff "Bestimmen" umfasst jedoch auch eine Verarbeitung eines solchen Ausgangssignals einer Einrichtung zur Erfassung. Das Zustandssignal kann ein Stromsignal oder ein Spannungssignal sein oder in Abhängigkeit solcher Signale bestimmt werden.

In einem zweiten Bestimmungsschritt wird der Gesundheitszustand in Abhängigkeit des Zustandssignals bestimmt. Der Gesundheitszustand kann insbesondere ein Alterungszustand sein. Der Gesundheitszustand kann z.B. als "nicht degradierter Zustand" oder als "degradierter Zustand" bestimmt werden. Selbstverständlich können auch andere oder weiter Zustände als Gesundheitszustand bestimmt werden, z.B. ein "nicht vollständig degradierter Zustand" oder ein quantitatives Maß für eine Degradation, z.B. in Form einer Prozentzahl und/oder in Form einer verbleibenden Lebensdauer. Es ist möglich, dass das Zustandssignal zur Bestimmung des Gesundheitszustands verarbeitet und/oder analysiert wird. Z.B. kann durch eine Signalanalyse mindestens eine Signaleigenschaft des Zustandssignals bestimmt werden. Diese mindestens eine Signaleigenschaft kann dann z.B. mit einem oder mehreren Schwellwerten verglichen werden, um den Gesundheitszustand zu bestimmen. Alternativ kann der Gesundheitszustand in Abhängigkeit einer vorbekannten Zuordnung zwischen Gesundheitszustand und Zustandssignal, insbesondere der mindestens einen Signaleigenschaft, bestimmt werden. Diese Zuordnung kann in Form einer Look-Up-Tabelle gegeben sein. Auch kann die Zuordnung in Form einer Funktion bereitgestellt sein. Es ist auch möglich, dass der Gesundheitszustand mit einem maschinell erlernten Modell (MLM) bestimmt wird, wobei das Zustandssignal bzw. die mindestens eine Signaleigenschaft einen Eingangsdatenpunkt für das MLM und der Gesundheitszustand einen Ausgangsdatenpunkt bildet. Selbstverständlich sind aber auch andere Verfahren zur Bestimmung des Gesundheitszustands in Abhängigkeit der Zustandssignals vorstellbar.

Wie nachfolgend noch näher erläutert, kann das Zustandssignal insbesondere durch eine Tiefpassfilterung und/oder eine Mittelung bestimmt werden, wodurch der Gesundheitszustand insbesondere in Abhängigkeit von niederfrequenten Anteilen bestimmt wird. Es ist aber selbstverständlich möglich, auch die hochfrequenten Anteile zu berücksichtigen, insbesondere indem ein MLM zur Bestimmung des Gesundheitszustands genutzt wird.

Erfindungsgemäß wird das Zustandssignal für einen Zustand bestimmt, in dem das Leistungshalbleiterelement mit einer Diagnosefrequenz betrieben, also geschaltet, wird, die höher als eine maximale Normalbetriebsfrequenz ist. Mit anderen Worten ist also das im ersten Bestimmungsschritt bestimmte Zustandssignal repräsentativ für einen Gate-Strom oder eine Gate-Spannung, die sich bei einem Betrieb des Leistungshalbleiterelements mit der Diagnosefrequenz einstellen.

Die maximale Normalbetriebsfrequenz bezeichnet die maximale Frequenz mit der das Leistungshalbleiterelement beim bestimmungsgemäßen Betrieb betrieben wird, z.B. um eine Wechselspannung bereitzustellen. Eine solche maximale Normalbetriebsfrequenz kann in einem Bereich von 2 kHz bis 100 kHz liegen. So kann die maximale Normalbetriebsfrequenz bei einem IGBT beispielsweise bei 20 kHz, bei einem (Si-)MOSFET bei 100 kHz und bei einem SiC-MOSFET bei 500 kHz liegen. Im Fall von GaN (Galliumnitrid)-Leistungshalbleiterelementen kann die maximale Normalbetriebsfrequenz bei 1 MHz liegen.

Die Diagnosefrequenz kann somit, abhängig vom verwendeten Leistungshalbleiterelement, größer als 1 kHz, vorzugsweise größer als 10 kHz, weiter vorzugsweise größer als 100 kHz, weiter vorzugsweise größer als 300 kHz und weiter vorzugsweise größer als 500 kHz sein, im Falle von GaN-Leistungshalbleiterelementen auch größer als 1 MHz sein.

Zur Bestimmung des Zustandssignals kann also eine aktuelle Frequenz, mit der das Leistungshalbleiterelement betrieben wird, erhöht werden, insbesondere um das 2fache, das 3fache oder sogar um mehr als 3fache. So kann zur Bestimmung des Zustandssignals ein Diagnosemodus aktiviert werden, insbesondere aus einem Normalbetriebsmodus in einen Diagnosemodus umgeschaltet werden. Als Folge der Aktivierung/des Umschaltens wird die Betriebsfrequenz des Leistungshalbleiterelements erhöht.

Alternativ oder kumulativ wird ein Gate-Widerstand des Leistungshalbleiterelements auf einen Diagnosewert eingestellt wird, der höher als ein maximaler Normalbetriebswiderstand ist. Die maximale Normalbetriebswiderstand bezeichnet den maximalen Gate-Widerstand, den das Leistungshalbleiterelement beim bestimmungsgemäßen Betrieb aufweist. Ein solcher maximaler Normalbetriebswiderstand kann in einem Bereich von 1 Ohm bis 50 Ohm liegen. So kann der maximale Normalbetriebswiderstand bei einem IGBT beispielsweise bei 50 Ohm, bei einem (Si-)MOSFET bei 20 Ohm und bei einem SiC-MOSFET bei 10 Ohm liegen.

Die Diagnosewert kann somit, abhängig vom verwendeten Leistungshalbleiterelement, größer als 10 Ohm, vorzugsweise größer als 120 Ohm, weiter vorzugsweise größer als 50 Ohm sein.

Zur Bestimmung des Zustandssignals kann also ein aktueller Wert des Gate-Widerstands erhöht werden, insbesondere um das 2fache, das 3fache oder sogar um mehr als 3fache. Als Folge der erläuterten Aktivierung/des Umschaltens kann also auch der aktuell eingestellte Gate-Widerstand des Leistungshalbleiterelements erhöht werden.

Durch das Einstellen einer höheren Betriebsfrequenz und/oder eines höheren Gate-Widerstands kann insbesondere ein zeitlicher Verlauf eines Gate-Stroms und/oder einer Gate-Spannung beeinflusst werden, sodass diese Größe(n) oder (eine) davon abhängige Größe(n) zuverlässiger, insbesondere mit einer erhöhten Messgenauigkeit, erfasst werden können. Wird das Zustandssignal für einen Zustand bestimmt, in dem das Leistungshalbleiterelement mit einer Diagnosefrequenz betrieben wird, so kann der Gate-Widerstand des Leistungshalbleiterelements von seinem aktuellen Wert reduziert werden. Dies verbessert insbesondere die Gewinnung von Informationen über Hochfrequenzelemente.

Z.B. kann sich, insbesondere durch Einstellen der Diagnosefrequenz, ein effektiver, insbesondere mittlerer, Gate-Strom mit Vergleich zu einer niedrigeren Frequenz erhöhen. Da bei einer erhöhten Frequenz die durch das Leistungshalbleiterelement am Gate-Anschluss bereitgestellte Kapazität weniger stark, insbesondere nicht mehr vollständig, aufgeladen oder entladen wird, ergibt sich bei der Diagnosefrequenz auch ein veränderter Signalverlauf der Gate-Spannung. Durch die Erhöhung des Gate-Widerstands kann eine Steigung, insbesondere einer steigenden und/oder fallenden Flanke, eines Gate-Stroms oder Gate-Spannungssignals beeinflusst, insbesondere verringert, werden, was ebenfalls in einem veränderten Signalverlauf resultiert. Die veränderten Signalverläufe wiederum bewirken, dass das Zustandssignal zuverlässiger, insbesondere mit einer erhöhten Messgenauigkeit, bestimmt werden kann.

Z.B. kann das Zustandssignal ein Gate-Stromsignal oder ein Gate-Spannungssignal sein, wobei der Gesundheitszustand in Abhängigkeit eines Effektiv- oder Mittelwerts eines solchen Zustandssignals bestimmt werden kann. Das Zustandssignal, welches für einen Zustand bestimmt wird, in dem das Leistungshalbleiterelement mit der Diagnosefrequenz betrieben wird, kann für eine Gate-Spannung oder einen Gate-Strom repräsentativ sein. Insbesondere kann das Zustandssignal in einer solchen Ausführungsform ein Gate-Strom- oder -Spannungssignal sein, wobei der Gesundheitszustand in Abhängigkeit eines Effektiv- oder Mittelwerts eines solchen Zustandssignals bestimmt werden kann. Das Zustandssignal, welches für einen Zustand bestimmt wird, in dem der Gate-Widerstand des Leistungshalbleiterelements auf eine Diagnosewert eingestellt wird, kann vorzugsweise für eine Gate-Spannung repräsentativ oder das Gate-Spannungssignal sein.

Es ist möglich, dass das Zustandssignal in Abhängigkeit von genau einem, insbesondere gemessenen, Strom- oder Spannungssignal bestimmt wird. Es ist aber auch möglich, dass das Zustandssignal in Abhängigkeit von mehreren verschiedenen, insbesondere gemessenen, Strom- und/oder Spannungssignalen bestimmt wird.

Somit ergibt sich in vorteilhafter Weise eine einfache und zuverlässige Bestimmung des Gesundheitszustands.

Der Betrieb des Leistungshalbleiterelements mit der Diagnosefrequenz und/oder mit einem auf den Diagnosewert eingestellten Gate-Widerstand, also der Diagnosemodus, kann abhängig von einer über das Leistungshalbleiterelement übertragenen Leistung eingestellt, insbesondere aktiviert, werden. Z.B. kann der Diagnosemodus nur dann aktiviert werden, wenn die über das Leistungshalbleiterelement übertragenen Leistung kleiner als ein vorbestimmter Schwellwert ist. Dies kann z.B. dann der Fall sein, wenn sich ein Fahrzeug mit dem Leistungshalbleiterelement in einem geparkten Zustand befindet. Somit ist es auch vorstellbar, dass der Diagnosemodus abhängig von einem Fahrzeugzustand eingestellt wird. Z.B. kann der Diagnosemodus nur dann aktiviert werden, wenn vorbestimmte Fahrzeugzustände, z.B. der erwähnte, eingestellt sind. Die vorbestimmten Fahrzeugzustände können insbesondere solche Zustände sein, in denen die über das Leistungshalbleiterelement übertragenen Leistung kleiner als der vorbestimmte Schwellwert ist. Ein weiterer beispielhafter Zustand ist ein Zustand, in dem die Fahrgeschwindigkeit kleiner als ein vorbestimmter Schwellwert ist, wobei ein Drain-Source-Strom des Leistungshalbleiterelements kleiner als ein vorbestimmter (weiterer) Schwellwert ist. Ein weiterer beispielhafter Zustand ist ein Zustand, in dem ein Lastwechselstrom des Leistungshalbleiterelements Null ist oder weniger als ein vorbestimmtes Maß von Null abweicht.

Wird mit dem Verfahren ein unerwünschter Gesundheitszustand, z.B. ein "degradierter Zustand", bestimmt, so kann ein Warnsignal erzeugt werden. Dies kann an eine Fahrzeugsteuersystem übermittelt werden. Wird ein solches Warnsignal erzeugt, so kann ein Betrieb des Fahrzeugs angepasst werden. Alternativ oder kumulativ kann es an einen Fahrzeugführer über eine entsprechende Ausgabeeinrichtung, z.B. ein Display, ausgegeben werden.

In einer weiteren Ausführungsform wird ein degradierter Zustand des Leistungshalbleiterelements detektiert, wenn das Zustandssignal kleiner als ein vorbestimmter minimaler Schwellwert oder größer als ein vorbestimmter maximaler Schwellwert ist. So kann z.B. ein minimaler Wert des Zustandssignals bestimmt und mit dem vorbestimmten minimalen Schwellwert verglichen werden. Auch kann z.B. ein maximaler Wert des Zustandssignals bestimmt und mit dem vorbestimmten maximalen Schwellwert verglichen werden. Ist das Zustandssignal z.B. ein Gate-Stromsignal oder für diese repräsentativ, so kann ein unerwünschter Gate-Oxid-Abbau, ein unerwünschtes Ladungstrapping oder ein unerwünschtes Verschieben einer Gate-Schwellenspannung detektiert werden, wenn das Zustandssignal kleiner als der vorbestimmte minimale Schwellwert ist. Ein unerwünscht hoher Leckstrom kann detektiert werden, wenn das Zustandssignal größer als der vorbestimmter maximale Schwellwert ist.

In einer weiteren Ausführungsform wird ein Messsignal erfasst, welches für die Gate-Spannung oder den Gate-Strom repräsentativ ist, wobei das Zustandssignal das Messsignal ist oder in Abhängigkeit des Messsignals bestimmt wird. Dies wurde vorhergehend bereits erläutert. Insbesondere kann der Gate-Strom, die Gate-Spannung oder ein Versorgungsstrom, also ein Strom zwischen einer Spannungsversorgungsquelle und der Gatetreiber-Einrichtung, als Messignal erfasst werden. Wie vorhergehend erläutert können auch mehrere verschiedene Messsignale zur Bestimmung des Zustandssignals berücksichtigt werden. In diesem Fall kann das Zustandssignal z.B. als Differenz von zwei Messsignalen gemessen werden, z.B. als Differenz eines primärseitigen Versorgungsstroms und eines sekundärseitigen Versorgungsstroms. Es ist z.B. auch vorstellbar, dass eine Spannungsversorgungsquelle mehrere Gatetreiber-Einrichtungen, z.B. die Gatetreiber-Einrichtungen aller Hochvolt-Leistungshalbleiterelement oder aller Niedervolt-Leistungshalbleiterelemente, versorgt. Dann kann in Abhängigkeit des Zustandssignals auch der Gesundheitszustand aller dieser Elemente bestimmt werden. Dies kann eine Zuverlässigkeit der Bestimmung erhöhen, da sich die Auswirkungen der Alterung aller dieser Elemente im Zustandssignal akkumulieren können.

Hierdurch ergibt sich in vorteilhafter Weise eine zuverlässige Bestimmung des Zustandssignals und somit eine zuverlässige Bestimmung des Gesundheitszustands.

In einer weiteren Ausführungsform wird das Zustandssignal als tiefpassgefiltertes Messignal und/oder als gemitteltes Messsignal bestimmt. Insbesondere kann das Messignal mit einer Tiefpassfiltereinrichtung gefiltert werden. Eine Grenzfrequenz der Tiefpassfiltereinrichtung kann beispielsweise abhängig von der Diagnosefrequenz gewählt werden. Z.B. kann die Grenzfrequenz in einem Frequenzbereich liegen, der Frequenzen kleiner als die Diagnosefrequenz, vorzugsweise kleiner als die Hälfte der Diagnosefrequenz, weiter vorzugsweise kleiner als ein Zehntel der Diagnosefrequenz liegt. Alternativ kann die Grenzfrequenz einem Vielfachen der elektrischen Frequenz einer elektrischen Antriebsmaschine, d.h. einer Frequenz des Last-Wechselstroms, entsprechen. Wird eine Hochpass- oder ein Bandpassfiltereinrichtung verwendet, so kann die Grenzfrequenz in einem Frequenzbereich liegen, der Frequenzen größer als die Diagnosefrequenz, vorzugsweise größer als ein Vielfaches der Diagnosefrequenz, umfasst.

Ein gemitteltes Messignal kann ein zeitlich gemitteltes Messsignal sein. Ein solches zeitlich gemitteltes Messignal kann insbesondere als gleitender Mittelwert bestimmt werden. Durch die Tiefpassfilterung und/oder Mittelung können insbesondere ein Effektivwert des Zustandssignals mit höherer Zuverlässigkeit bestimmt werden, was wiederum in vorteilhafter Weise die Zuverlässigkeit der Bestimmung des Gesundheitszustands erhöht.

In einer weiteren Ausführungsform wird zur Bestimmung des Zustandssignals das Messignal mit einer Abtastfrequenz abgetastet, die geringer als die doppelte Diagnosefrequenz ist. Hierdurch werden Eigenschaften des Messsignals ähnlich einer Tiefpassfilterung und/oder Mittelwertbildung beeinflusst, was - wie vorhergehend erläutert - in vorteilhafter Weise die Zuverlässigkeit der Bestimmung des Gesundheitszustands erhöht. Als zusätzlicher Vorteil ergibt sich, dass eine einfache und kostengünstige Implementierung des Verfahrens ermöglicht wird, insbesondere da kein teurer ADC-Wandler notwendig sind.

In einer weiteren Ausführungsform wird als Messignal ein Strom von einer Spannungsversorgungsquelle zu der Gatetreiber-Einrichtung, also ein Versorgungsstrom, erfasst. Ist die Gatetreiber-Einrichtung eine isolierte Gatetreiber-Einrichtung, so gibt es zwei Alternativen. Das Messignal kann ein primärseitiger Versorgungsstrom, insbesondere also ein Strom von der vorhergehend erläuterten primärseitigen Spannungsversorgungsquelle zu einem primärseitigen Spannungsversorgungsanschluss sein. Alternativ kann das Messsignal ein sekundärseitiger Versorgungsstrom, insbesondere also ein Strom von der vorhergehend erläuterten sekundärseitigen Spannungsversorgungsquelle zu einem sekundärseitigen Spannungsversorgungsanschluss sein. Diese Versorgungsströme sind repräsentativ für den Gate-Strom und weisen ähnliche Eigenschaften wie ein tiefpassgefilterter und/oder gemittelter Gate-Strom auf, was - wie vorhergehend erläutert - in vorteilhafter Weise die Zuverlässigkeit der Bestimmung des Gesundheitszustands erhöht. Als zusätzlicher Vorteil ergibt sich, dass entsprechende Stromsensoren einfach verbaut werden können und die Messung weniger durch Rauschen oder Störsignale, die insbesondere vom Leistungshalbleiterelement erzeugt werden, beeinflusst und somit genauer wird.

In der erläuterten zweiten Alternative ergibt sich zudem als Vorteil, dass die Messung isoliert von der Primärseite erfolgen kann.

Alternativ wird als Messsignal ein Strom oder eine Spannung entlang einer elektrischen Verbindung zwischen einem, insbesondere primärseitigen, Gatetreiber-Anschluss und einem Gate-Anschluss des Leistungshalbleiterelements erfasst.

Insbesondere kann das Messsignal direkt am Gatetreiber-Anschluss oder nicht mehr als einen vorbestimmten Abstand entlang der elektrischen Verbindung mit dem Gate-Anschluss beabstandet von dem Gatetreiber-Anschluss erfasst werden. Hierdurch ergibt sich in vorteilhafter Weise eine gute Zugänglichkeit für die Anordnung eines entsprechenden Sensors, da dieser nicht direkt am Halbleiterbauelement angeordnet werden muss.

Auch kann das Messsignal direkt am Gate-Anschluss oder nicht mehr als einen vorbestimmten Abstand entlang der elektrischen Verbindung mit dem Gatetreiber-Anschluss beabstandet von dem Gate-Anschluss erfasst werden. Eine solche Anordnung ist insbesondere bevorzugt, wenn als Zustandssignal die Gate-Spannung in einem Zustand bestimmt wird, in dem ein Gate-Widerstand des Leistungshalbleiterelements auf eine Diagnosewert eingestellt wird, da die Erhöhung des Widerstands bei einer solchen Erfassung stärkeren Einfluss auf die Gate-Spannung, insbesondere auf deren zeitlichen Verlauf, hat.

Auch kann das Messsignal zwischen Gatetreiber-Anschluss und Gate-Anschluss, also mehr mehr als einen vorbestimmten Abstand entlang der elektrischen Verbindung zwischen den Anschlüssen beabstandet von jeweils den beiden Anschlüssen erfasst werden. Auch hierdurch ergibt sich in vorteilhafter Weise eine gute Zugänglichkeit für die Anordnung eines entsprechenden Sensors, da dieser nicht direkt am Halbleiterbauelement angeordnet werden muss.

Wird als Messsignal ein Strom erfasst, so kann dies vorzugsweise mit einem Stromsensor mit vorbestimmten Tiefpasseigenschaften erfolgen. In der Regel weisen Stromsensoren bereit inhärente Tiefpasseigenschaften auf, sodass also in vorteilhafter Weise bereits verfügbare Stromsensoren genutzt werden können.

In einer weiteren Ausführungsform ist die Diagnosefrequenz größer als 1 kHz, vorzugsweise größer als 10 kHz, weiter vorzugsweise größer als 100 kHz. Dies und entsprechende Vorteile wurden vorhergehend bereits erläutert.

In einer weiteren Ausführungsform wird das Zustandssignal für mehrere voneinander verschiedene Diagnosefrequenzen und/oder für mehrere voneinander verschiedene Diagnosewerte bestimmt, wobei der Gesundheitszustand in Abhängigkeit der frequenzspezifischen Zustandssignale bestimmt wird. Alle Diagnosefrequenzen und/oder alle Diagnosewerte können höher als die maximale Normalbetriebsfrequenz bzw. der maximale Normalbetriebswiderstand sein. Z.B. kann ein frequenzabhängiger Verlauf zumindest einer Signaleigenschaft und der Gesundheitszustand in Abhängigkeit des Verlaufs bestimmt werden. Hierdurch kann in vorteilhafter Weise die Zuverlässigkeit der Bestimmung des Gesundheitszustands erhöht werden.

In einer weiteren Ausführungsform wird der Gate-Widerstand erhöht, indem ein einstellbarer Widerstand eines Widerstandselements in einer elektrischen Verbindung von Gatetreiber-Einrichtung und Gate-Anschluss erhöht wird oder indem eine Widerstandseigenschaft der Gatetreiber-Eirichtung verändert wird. Das Widerstandselement kann ein Element mit einem kontinuierlich oder diskret einstellbaren Widerstand sein, welches insbesondere die Einstellung mindestens einen Widerstandswert zwischen einem minimal einstellbaren Widerstandswert und einem maximal einstellbarem Widerstandswert ermöglicht. Ein solches Widerstandselement kann insbesondere ein FET (Feldeffekttransistor) sein. Die Widerstandseigenschaft der Gatetreiber-Einrichtung kann verändert werden, indem ein Ausgangswiderstand am Gatetreiber-Ausgangsanschluss oder eine Impedanz, die die Gatetreiber-Einrichtung dem Gate-Anschluss gegenüber hat, verändert wird. Hierdurch ergibt sich in vorteilhafter Weise eine einfach implementierbare Erhöhung des Gate-Widerstands.

Weiter vorgeschlagen wird eine Vorrichtung zur Bestimmung eines Gesundheitszustands eines Leistungshalbleiterelements, umfassend zumindest eine Einrichtung zur Bestimmung eines Zustandssignals und eine Auswerteeinrichtung, wobei mittels der Einrichtung zur Bestimmung des Zustandssignals ein Zustandssignal erfasst wird, welches für eine Gate-Spannung oder einen Gate-Strom repräsentativ ist, wobei der Gesundheitszustand mittels der Auswerteeinrichtung in Abhängigkeit des Zustandssignals bestimmt wird.

Erfindungsgemäß wird das Zustandssignal für einen Zustand bestimmt wird, in dem das Leistungshalbleiterelement mit einer Diagnosefrequenz betrieben wird, die höher als eine maximale Normalbetriebsfrequenz ist und/oder in dem ein Gate-Widerstand des Leistungshalbleiterelements auf eine Diagnosewert eingestellt wird, der höher als ein maximaler Normalbetriebswiderstand ist. Mit anderen Worten ist die vorgeschlagene Vorrichtung konfiguriert, ein Verfahren gemäß einer der in dieser Offenbarung beschriebenen Ausführungsform mit den diesbezüglich erläuterten technischen Vorteilen durchzuführen.

Die Vorrichtung kann das Leistungshalbleiterelement und/oder die Gatetreiber-Einrichtung und/oder die vorhergehend erläuterte Steuereinrichtung umfassen. Die Steuereinrichtung kann die Auswerteeinrichtung bereitstellen. Alternativ kann die Auswerteeinrichtung auch durch eine Recheneinrichtung eines übergeordneten Systems bereitgestellt sein.

Weiter beschrieben wird ein Fahrzeug, insbesondere ein Elektro- oder Hybridfahrzeug, mit einer solchen Vorrichtung. Das Leistungshalbleiterelement kann Teil eines Traktionsnetzes dieses Fahrzeugs sein und insbesondere zur Bereitstellung einer Wechselspannung für eine elektrische Antriebseinrichtung des Fahrzeugs dienen.

Die Erfindung wird anhand von Ausführungsbeispielen näher erläutert. Die Figuren zeigen:
- Fig. 1: ein schematisches Blockschaltbild einer erfindungsgemäßen Vorrichtung,
- Fig. 2: ein schematisches Flussdiagramm eines erfindungsgemäßen Verfahrens,
- Fig. 3: ein schematischer zeitlicher Verlauf eine Zustandssignals,
- Fig. 4: einen weiteren schematischen Verlauf eines Zustandssignals.

Nachfolgend bezeichnen gleiche Bezugszeichen Elemente mit gleichen oder ähnlichen technischen Merkmalen.

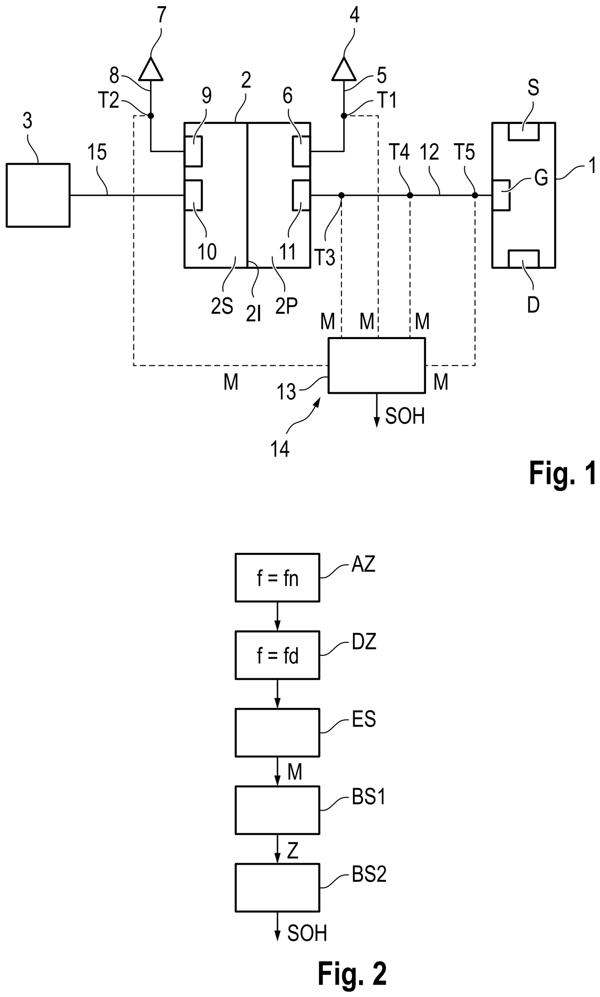

Fig. 1 zeigt ein schematisches Blockschaltbild einer erfindungsgemäßen Vorrichtung 14. Dargestellt ist ein Leistungshalbleiterelement 1, welches insbesondere als Si-MOSFET oder SiC-MOSFET ausgebildet sein kann. Dieses weist einen Gate-Anschluss G sowie einen Drain-Anschluss D und einen Source-Anschluss auf. Ebenfalls dargestellt ist eine Gatetreiber-Einrichtung 2 und eine Steuereinrichtung 3 für die Gatetreiber-Einrichtung. In dem dargestellten Ausführungsbeispiel ist die Gatetreiber-Einrichtung 2 als isolierte Gatetreiber-Einrichtung ausgebildet und weist eine Primärseite 2P und eine Sekundärseite 2S auf, wobei zwischen diesen Seiten 2P, 2S eine Isolation 2I vorhanden ist.

Ebenfalls dargestellt ist eine primärseitige Spannungsversorgungsquelle 4, die über eine Versorgungsleitung 5 mit einem primärseitigen Versorgungsanschluss 6 elektrisch verbunden ist. Auch dargestellt ist eine sekundärseitige Spannungsversorgungsquelle 7, die über eine Versorgungsleitung 8 mit einem sekundärseitigen Versorgungsanschluss 9 elektrisch verbunden ist. Die Spannungsversorgungsquellen 4, 7 können insbesondere Konstantspannungsquellen sein.

Die Steuereinrichtung 3 ist über eine Steuerleitung 15 mit einem sekundärseitigen Steueranschluss 10 der Gatetreiber-Einrichtung 2 verbunden. Die Gatetreiber-Einrichtung 2 ist über einen primärseitigen Gatetreiber-Anschluss 11, eine Verbindungsleitung 12 mit dem Gate-Anschluss G elektrisch verbunden.

Schematisch dargestellt sind verschiedene mögliche Messpunkte T1, T2, T3, T4, T5 zur Erfassung eines Messsignals M, welches zur Bestimmung eines Zustandssignal Z (siehe Fig. 2) von einer entsprechenden Erfassungseinrichtung (nicht dargestellt) erfasst werden kann. So kann z.B. als Messsignal M ein Versorgungsstrom in der Versorgungsleitung 5 zwischen der primärseitigen Spannungsversorgungsquelle 4 und dem primärseitigen Versorgungsanschluss 6 an einem ersten Messpunkt T1 erfasst werden. Alternativ kann als Messsignal M ein Versorgungsstrom in der Versorgungsleitung 8 zwischen der sekundärseitigen Spannungsversorgungsquelle 7 und dem sekundärseitigen Versorgungsanschluss 9 an einem zweiten Messpunkt T2 erfasst werden. Weiter alternativ kann als Messignal M ein Gate-Strom an einem dritten Messpunkt T3, der direkt am primärseitigen Gatetreiber-Anschluss 11 angeordnet ist, erfasst werden. Weiter alternativ kann als Messignal M ein Gate-Strom an einem vierten Messpunkt T4, der entlang der Verbindungsleitung 12 zwischen Gate-Anschluss G und Gatetreiber-Anschluss 11 angeordnet ist, erfasst werden. Weiter alternativ kann als Messignal M ein Gate-Strom oder eine Gate-Spannung an einem fünften Messpunkt T5, der direkt am Gate-Anschluss G angeordnet ist, erfasst werden.

Die erläuterten Messsignale sind also entweder der Gate-Strom oder die Gate-Spannung oder sind für diese(n) repräsentativ. Hierbei wird davon ausgegangen, dass ein Verändern der am Gatetreiber-Anschluss 11 bereitgestellt Spannung auch eine Veränderung der Versorgungsströme bedingt.

Das Messsignal M wird in einem Diagnosezustand DZ erfasst, wobei in dem Diagnosezustand das Leistungshalbleiterelement 1 mit einer Diagnosefrequenz fd betrieben wird, die höher als eine maximale Normalbetriebsfrequenz fn ist und/oder in dem ein Gate-Widerstand des Leistungshalbleiterelements 1 auf eine Diagnosewert eingestellt wird, der höher als ein maximaler Normalbetriebswiderstand ist. Dies wurde vorgehend bereits erläutert.

Die Messsignale M werden einer Auswerteeinrichtung 13 zugeführt. Hierbei können die Messsignale gefiltert werden, insbesondere mittels nicht dargestellter Tiefpassfiltereinrichtungen. Die Auswerteeinrichtung 13 kann das Zustandssignal Z bestimmen, welches durch das, gegebenenfalls gefilterte, Messsignal M gebildet wird oder in Abhängigkeit dieses Messsignals M bestimmt wird. Insbesondere kann die Auswerteeinrichtung 13 einen, insbesondere gleitenden, Mittelwert des Messsignals M bestimmen. Alternativ oder kumulativ kann die Auswerteeinrichtung 13 das Messsignal M mit einer Abtastfrequenz abtasten, die geringer als die doppelte Diagnosefrequenz fd ist.

Weiter kann die Auswerteeinrichtung 13 einen Gesundheitszustands SOH in Abhängigkeit des Zustandssignals Z bestimmen und gegebenenfalls über eine geeignete Signalschnittstelle (nicht dargestellt) an ein übergeordnetes System übermitteln.

Die erfindungsgemäße Vorrichtung 14 umfasst also die Auswerteeinrichtung 13 und die mindestens eine (nicht dargestellte) Erfassungseinrichtung zur Erfassung des Messsignals M, wobei diese eine Einrichtung zur Bestimmung des Zustandssignals Z oder einen Teil davon bilden kann.

Fig. 2 zeigt ein schematisches Flussdiagramm eines erfindungsgemäßen Verfahrens.

Dargestellt ist ein Ausgangszustand AZ, in dem das in z.B. in Fig. 1 dargestellte Leistungshalbleiterelement 1 mit einer Frequenz f betrieben, also geschaltet wird, die einer Normalbetriebsfrequenz fn entspricht. Rein exemplarisch kann diese 20 kHz betragen. Der Ausgangszustand kann ein Normalbetriebszustand sein. Dann wird ein Diagnosezustand DZ aktiviert. Insbesondere kann der Normalbetriebszustand in den Diagnosezustand DZ umgeschaltet werden. Dies kann periodisch erfolgen, wobei das Aktivieren nur dann erfolgt, wenn die zum Aktivierungszeitpunkt über das Leistungshalbleiterelement 1 übertragene Leistung kleiner als ein vorbestimmter Schwellwert ist. Im Diagnosezustand wird das Leistungshalbleiterelement 1 mit einer Frequenz f betrieben, die einer Diagnosefrequenz fd entspricht, wobei die Diagnosefrequenz fd höher als die maximale Normalbetriebsfrequenz ist. Mit anderen Worten wird die Betriebsfrequenz des Leistungshalbleiterelements 2 erhöht.

Alternativ oder kumulativ kann bei der Aktivierung des Diagnosezustands DZ ein Gate-Widerstand des Leistungshalbleiterelements 1 auf eine Diagnosewert eingestellt wird, der höher als ein maximaler Normalbetriebswiderstand ist. So kann z.B. in der Verbindungsleitung 12 zwischen Gate-Anschluss G und Gatetreiber-Anschluss 11 eine FET mit einstellbarem Widerstand angeordnet sein, dessen Widerstand bei der Aktivierung des Diagnosezustands DZ erhöht wird.

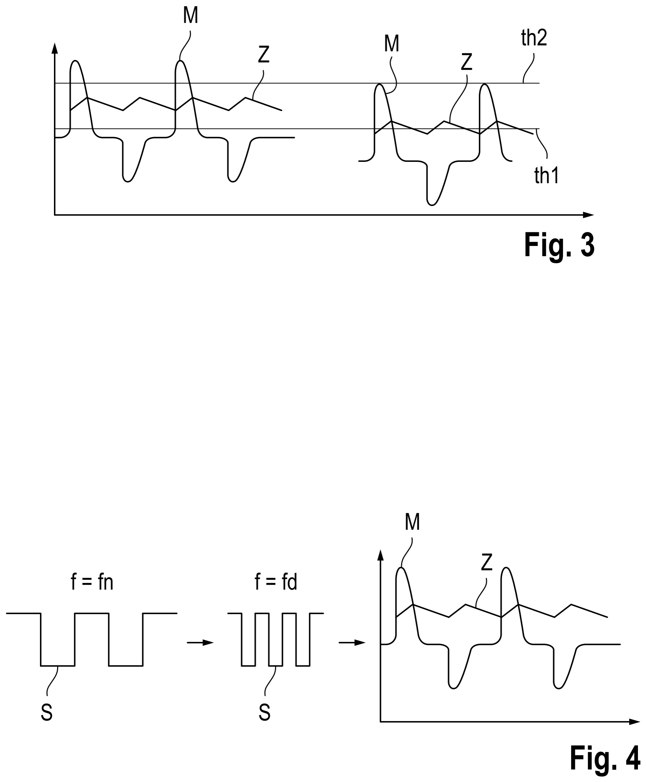

Im Diagnosezustand DZ wird dann in einem Erfassungsschritt ES als Messignal M ein Gate-Strom, eine Gate-Spannung oder ein für diese(n) repräsentatives Signal erfasst. Dies wurde in Bezug auf Fig. 1 bereits erläutert. In einem ersten Bestimmungsschritt BS1 wird ein Zustandssignal Z als das erfasste Messsignal M oder in Abhängigkeit davon bestimmt. Auch dies wurde in Bezug auf die in Fig. 1 dargestellte Ausführungsform bereits erläutert. In einem weiteren Bestimmungsschritt BS2 wird dann ein Gesundheitszustand SOH in Abhängigkeit des Zustandssignals Z bestimmt. Z.B. kann als Gesundheitszustand SOH ein degradierter Zustand des Leistungshalbleiterelements 1 bestimmt werden, wenn das Zustandssignal Z kleiner als ein vorbestimmter minimaler Schwellwert th1 oder größer als ein vorbestimmter maximaler Schwellwert th2 (siehe Fig. 3) ist. Nach dem Erfassungsschritt ES kann der Diagnosezustand DZ deaktiviert werden und insbesondere wieder ein Normalbetriebszustand, z.B. der Ausgangszustand AZ, eingestellt werden.

Fig. 3 zeigt einen schematischen zeitlichen Verlauf eines Zustandssignals Z, welches insbesondere in Abhängigkeit eines Messsignals M bestimmt wird, wobei als Messsignal M ein Gate-Strom oder eine für diesen repräsentative Größe bestimmt wird. Insbesondere kann ein solches Messsignal an einer der in Fig. 1 dargestellten Messstellen T1, T2, T3, T4, T5 erfasst werden. Das derart erfasste Messsignal M wird mit einem Tiefpassfilter gefiltert, wobei das gefilterte Signal das Zustandssignal Z ist. Weiter dargestellt ist ein vorbestimmter minimaler Schwellwert th1 und ein vorbestimmter maximaler Schwellwert th2, der größer als der vorbestimmte minimale Schwellwert th1 ist. Ist das Zustandssignal Z kleiner als der vorbestimmte minimale Schwellwert th1 oder größer als der vorbestimmte maximale Schwellwert th2, dann wird als Gesundheitszustand SOH ein degradierter Zustand bestimmt.

Fig. 4 zeigt einen weiteren schematischen Verlauf eines Zustandssignals Z. Dieses Zustandssignal Z wird als tiefpassgefiltertes Messsignal M bestimmt, wobei als Messsignal M eine Gate-Source-Spannung oder eine Drain-Source-Spannung erfasst wird, z.B. an dem fünften Messpunkt T5 (siehe Fig. 1). Dargestellt ist ein Schaltsignal S für ein Leistungshalbleiterelement 1, welches in einem Ausgangszustand AZ eine Normalbetriebsfrequenz fn aufweist. Ebenfalls dargestellt ist das Schaltsignal S in einem Diagnosezustand DZ, wobei es darin eine Diagnosefrequenz fd aufweist, die höher die Normalbetriebsfrequenz fn ist. Weiter dargestellt ist das Messsignal M, welches im Diagnosezustand DZ erfasst wird, sowie das resultierende Zustandssignal Z. Entsprechend den Ausführungen zu Fig. 3 kann das Zustandssignal Z mit einem oder mehreren vorbestimmten Schwellwerten verglichen werden, um einen Gesundheitszustand SOH zu bestimmen.

Ein ähnlicher Verlauf des Zustandssignals Z ergibt sich, wenn alternativ zur Erhöhung der Betriebsfrequenz ein Gate-Widerstand des Leistungshalbleiterelements 1 erhöht wird.

### Bezugszeichenliste

- 1: Leistungshalbleiterelement
- 2: Gatetreiber-Einrichtung
- 3: Steuereinrichtung
- 4: Spannungsversorgungsquelle
- 5: Versorgungsleitung
- 6: Versorgungsanschluss
- 7: Spannungsversorgungsquelle
- 8: Versorgungsleitung
- 9: Versorgungsanschluss
- 10: Steueranschluss
- 11: Gatetreiber-Anschluss
- 12: Verbindungsleitung
- 13: Auswerteeinrichtung
- 14: Vorrichtung
- 15: Steuerleitung
- G: Gate-Anschluss
- S: Source-Anschluss
- D: Drain-Anschluss
- 2P: Primärseite
- 2S: Sekundärseite
- 2I: Isolation
- T1,T2,T3 T4, T5: Messpunkt
- M: Messsignal
- Z: Zustandssignal
- AZ: Ausgangszustand
- DZ: Diagnosezustand
- SOH: Gesundheitszustand
- f: (Betriebs)Frequenz
- fn: Normalbetriebsfrequenz
- fd: Diagnosefrequenz
- ES: Erfassungsschritt
- BS1: erster Bestimmungsschritt
- BS2: weiterer Bestimmungsschritt
- th1: vorbestimmter minimaler Schwellwert
- th2: vorbestimmter maximaler Schwellwert
- S: Schaltsignal

## Patentansprüche

1. Verfahren zur Bestimmung eines Gesundheitszustands (SOH) mindestens eines Leistungshalbleiterelements (1), umfassend die Schritte:
• Bestimmen eines Zustandssignals (Z), welches für eine Gate-Spannung oder einen Gate-Strom repräsentativ ist,
• Bestimmen des Gesundheitszustands (SOH) in Abhängigkeit des Zustandssignals (Z),
**dadurch gekennzeichnet, dass**
das Zustandssignal (Z) für einen Zustand bestimmt wird, in dem das Leistungshalbleiterelement (1) mit einer Diagnosefrequenz (fd) betrieben wird, die höher als eine maximale Normalbetriebsfrequenz (fn) ist und/oder in dem ein Gate-Widerstand des Leistungshalbleiterelements (1) auf eine Diagnosewert eingestellt wird, der höher als ein maximaler Normalbetriebswiderstand ist.

2. Verfahren nach Anspruch 1, **dadurch gekennzeichnet, dass** ein degradierter Zustand des Leistungshalbleiterelements (1) detektiert wird, wenn das Zustandssignal (Z) kleiner als ein vorbestimmter minimaler Schwellwert (th1) oder größer als ein vorbestimmter maximaler Schwellwert (th2) ist.

3. Verfahren nach Anspruch 1 oder 2, **dadurch gekennzeichnet, dass** ein Messsignal (M) erfasst wird, welches für die Gate-Spannung oder den Gate-Strom repräsentativ ist, wobei das Zustandssignal (Z) das Messsignal (M) ist oder in Abhängigkeit des Messsignals (M) bestimmt wird.

4. Verfahren nach Anspruch 3, **dadurch gekennzeichnet, dass** das Zustandssignal (Z) als tiefpassgefiltertes Messignal (M) und/oder als gemitteltes Messsignal (M) bestimmt wird.

5. Verfahren nach Anspruch 3 oder 4, **dadurch gekennzeichnet, dass** zur Bestimmung des Zustandssignals (Z) das Messignal (M) mit einer Abtastfrequenz abgetastet wird, die geringer als die doppelte Diagnosefrequenz ist.

6. Verfahren nach einem der Ansprüche 3 bis 5, **dadurch gekennzeichnet, dass** als Messignal (M)
• ein Strom von einer Spannungsversorgungsquelle (4, 7) zu einer Gatetreiber-Einrichtung (2),
• ein Strom oder eine Spannung entlang einer elektrischen Verbindung (12) zwischen einem Gatetreiber-Anschluss (11) und einem Gate-Anschluss (G) erfasst wird.

7. Verfahren nach einem der vorangegangenen Ansprüche, **dadurch gekennzeichnet, dass** die Diagnosefrequenz (fd) größer als 1 kHz, vorzugsweise größer als 10 kHz, weiter vorzugsweise größer als 100 kHz ist.

8. Verfahren nach einem der vorangegangenen Ansprüche, **dadurch gekennzeichnet, dass** das Zustandssignal (Z) für mehrere voneinander verschiedene Diagnosefrequenzen (fd) und/oder für mehrere voneinander verschiedene Diagnosewerte bestimmt wird, wobei der Gesundheitszustand (SOH) in Abhängigkeit der frequenzspezifischen Zustandssignale bestimmt wird.

9. Verfahren nach einem der vorangegangenen Ansprüche, **dadurch gekennzeichnet, dass** der Gate-Widerstand erhöht wird, indem ein einstellbarer Widerstand eines Widerstandselements in einer elektrischen Verbindung (12) von Gatetreiber-Einrichtung (2) und Gate-Anschluss (G) erhöht wird oder indem eine Widerstandseigenschaft der Gatetreiber-Einrichtung (2) verändert wird.

10. Vorrichtung zur Bestimmung eines Gesundheitszustands (SOH) mindestens eines Leistungshalbleiterelements (1), umfassend zumindest eine Einrichtung zur Bestimmung eines Zustandssignals (Z) und eine Auswerteeinrichtung (13), wobei mittels der Einrichtung zur Bestimmung eines Zustandssignals (Z) ein Zustandssignal (Z) erfasst wird, welches für eine Gate-Spannung oder einen Gate-Strom repräsentativ ist, wobei der Gesundheitszustand (SOH) mittels der Auswerteeinrichtung (13) in Abhängigkeit des Zustandssignals (Z) bestimmt wird, **dadurch gekennzeichnet, dass** das Zustandssignal (Z) bestimmt wird, wenn
• das Leistungshalbleiterelement (1) mit einer Diagnosefrequenz (fd) betrieben wird, die höher als eine maximale Normalbetriebsfrequenz (fn) ist,
• ein Gate-Widerstand des Leistungshalbleiterelements (1) auf einen Diagnosewert eingestellt wird, der höher als ein maximaler Normalbetriebswiderstand ist.
